# EUROPEAN PATENT SPECIFICATION

(11) **EP 0 683 434 B1**
(45) Date of publication and mention of the grant of the patent: **02.12.1998**
(21) Application number: 95107406.1
(22) Date of filing: 15.05.1995
(51) Int. Cl.: G03F 7/029, G03C 7/12

(54) **Photo-polymerizable composition, and image forming method and color filter using the composition**
Fotopolymerisierbare Zusammensetzung, Bildherstellungsverfahren, das diese Zusammensetzung benutzt und Farbfilter, der aus dieser Zusammensetzung hergestellt wird
Composition photopolymérisable, procédé de formation d'images utilisant cette composition et filtre couleur préparé à partir de cette composition

(30) Priority: 16.05.1994 JP 101260/94
(43) Date of publication of application: 22.11.1995
(73) Proprietor: FUJI PHOTO FILM CO., LTD., Kanagawa-ken (JP)
(72) Inventor: Kobayashi, Kesanao, c/o Fuji Photo Film Co.,Ltd., Haibara-gun, Shizuoka (JP)
(74) Representative: Barz, Peter, Dr.

(56) References cited:
- EP-A- 0 359 934
- US-A- 4 341 860
- US-A- 4 505 793

## Description

The present invention relates to an image-forming material useful for forming color filters used in liquid crystal display devices, resists for printing substrates, and photosensitive lithographic printing plates, and also to an image-forming method using the material.

Color filters used in color liquid crystal display devices have fine pixels composed of red (R), green (G), blue (B) and, as the case may be, black (K), which are regularly disposed on a glass substrate. The pixels are formed by, for example, a staining method, a printing method, a pigment dispersing method, and an electro-depositing method.

According to these methods, each color pixel is formed one by one. Of these methods, a pigment dispersing method is advantageous since it gives accurate patterns and the steps constituting the method are stable. For these reasons, many color filters are produced by this method.

JP-A-62-298304 (the term "JP-A" as used herein means an "unexamined published Japanese patent application") discloses a material used in the pigment dispersing method and a color filter made of the material. The material comprises a transparent dispersion comprising an organic pigment dispersed in a photo-polymerizable composition. The dispersion, is coated on a glass substrate and dried, and thereafter an aqueous solution of polyvinyl alcohol is coated over the surface of the coated layer on the substrate, then exposed and developed. These steps are repeated to obtain a color filter.

When the photo-polymerizable composition is polymerized by exposure, the polymerization reaction is inhibited by oxygen. Therefore, the polyvinyl alcohol is coated to protect the photo-polymerizable composition from the oxygen. The polyvinyl alcohol film is needed only during the exposure step. If the step of coating such an oxygen-blocking polyvinyl alcohol film is omitted, the step of coating and removing the polyvinyl alcohol will be omitted, the cost of the polyvinyl alcohol will be omitted, the decrease in the yield due to the additional steps of coating and removing the polyvinyl alcohol will be prevented, and the costs for the coating devices and also for the space for the coating devices will be omitted. For these reasons, photosensitive materials having no oxygen-blocking polyvinyl alcohol film has been strongly desired.

It is well known that the oxygen has an influence on the photo-polymerizable composition because the radicals generated from an addition polymerization initiator in the composition by exposure are quenched by oxygen, and that the influence of oxygen depends on the kind of the addition polymerization initiator. Image-forming materials containing an initiator disclosed in, for example, JP-B-3-19842 (the term "JP-B" as used herein means an "examined Japanese patent publication"), JP-A-2-153353, JP-B-59-1281 and US-A-4,147,552 were prepared and exposed in the absence of an oxygen-blocking film, with the result that some particular photo-polymerization initiators were good but some others were not. Precisely, it was found that the coat made of the image-forming material containing a particular photo-polymerization initiator was not thinned by exposure in the absence of an oxygen-blocking film followed by development to give good pixels at high resolution. However, image-forming materials containing any other photo-polymerization initiator, though having high sensitivity in the presence of an oxygen-blocking film, were problematic when exposed in the absence of an oxygen-blocking film in that the pixels formed were peeled during development or were thinned even though exposure of 10 times or more the ordinary one was applied thereto.

An object of the present invention is to provide a photo-polymerizable composition that does not need an oxygen-blocking film such as polyvinyl alcohol film.

Another object of the present invention is to provide an image forming method using the composition.

A further object of the present invention is to provide a method for producing a color filter using the composition.

These and other objects of the present invention have been attained by a photo-polymerizable composition, which comprises (1) at least one photo-polymerizable ethylenically unsaturated compound having at least two terminal ethylene groups and having a boiling point of 100°C or higher at normal pressure and (2) an addition polymerization initiator activated by irradiation of an active electromagnetic wave, said addition polymerization initiator (2) comprising a combination of a compound (A) as specified below and a 3-aryl-substituted coumarin compound (B) as further specified below. Said composition differs from that disclosed in US-A-4,505,793 in that the 3-aryl-substituted coumarin compound (B) replaces the 3-keto-substituted coumarin compound employed in the composition of said document.

Further, these and other objects of the present invention have been attained by a process for forming an image, which comprises the steps of coating the above-described photo-polymerizable composition on a substrate surface, and exposing and developing it.

Moreover, these and other objects of the present invention have been attained by a color filter obtainable by repeating an operation comprising the steps of coating a transparent substrate surface with the above-described photo-polymerizable composition containing (a) an organic polymer having a water-soluble functional group in a part of its side chains and (b) an organic pigment, and exposing and developing it, thereby forming red, green and blue patterns on one and the same transparent substrate surface.

The present invention will be described in detail hereinunder.

The compound (A) for use in the present invention is selected from those of the following formulae (II), (III) and (IV) as disclosed, e.g., in JP-B-59-1281 and JP-A-53-133428, respectively.

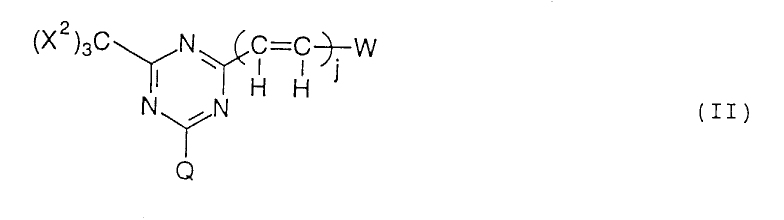

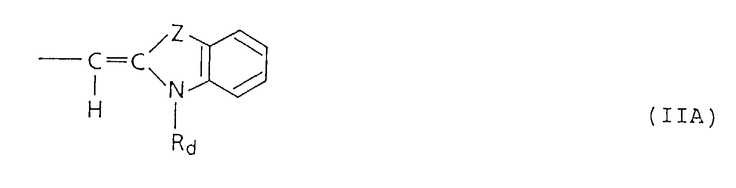

In formula (II), X² represents -Br or -Cl;
Q represents -CX₃, -NH₂, -NHRb, or -ORc, in which Rb and Rc each independently represents a phenyl group or an alkyl group;
W represents an aromatic or heterocyclic group, which may be substituted or a group represented by formula (IIA);
Z represents -O- or -S-;
Rd represents a hydrogen atom, an aryl group, or an alkyl group; and
j represents 0 or an integer of from 1 to 3.

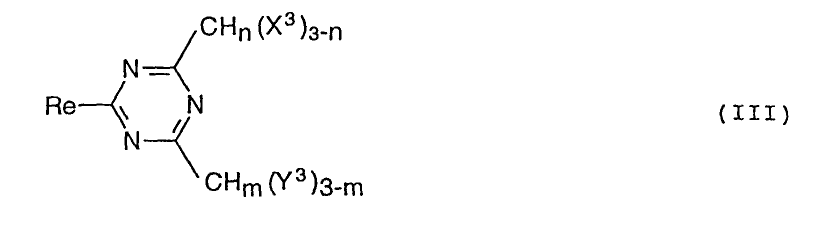

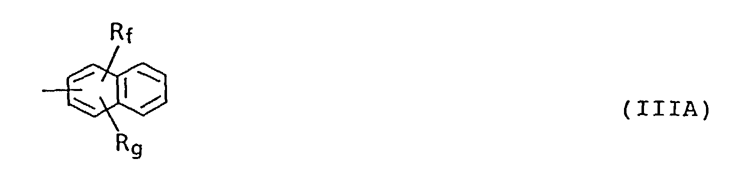

In formula (III), X³ and Y³ each independently represents -Br or -Cl;
m and n each independently represents 0 or an integer of from 1 to 3; provided that they are not 3 at the same time ;
Re represents a group represented by formula (IIIA);
Rf represents -H or -OR, in which R represents an alkyl group, a cycloalkyl group, an alkenyl group or an aryl group; and
Rg represents. -H, -Cl, -Br, an alkyl group, an alkenyl group, an aryl group or an alkoxy group.

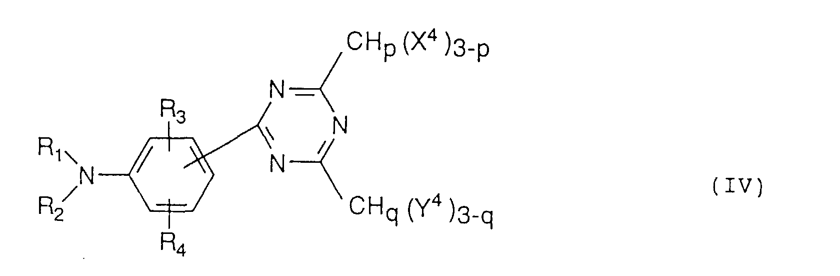

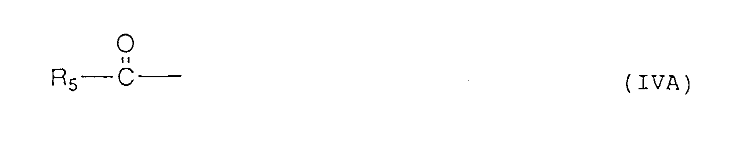

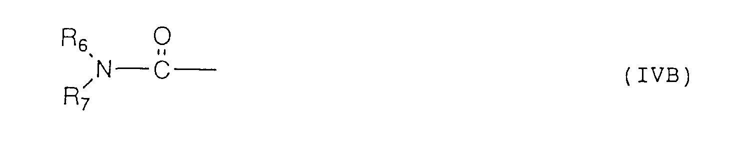

In formula (IV), R₁ and R₂ each independently represents -H, an alkyl group, a substituted alkyl group, an aryl group, a substituted aryl group, or a group represented by formula (IVA) or (IVB);
R₃ and R₄ each independently represents -H, a halogen atom, an alkyl group, or an alkoxy group;
X⁴ and Y⁴ each independently represents -Cl or -Br;
p and q each independently represents 0, 1 or 2; and
R₅, R₆ and R₇ each independently represents an alkyl group, a substituted alkyl group, an aryl group, or a substituted aryl group.

Examples of the substituents for the substituted alkyl group and the substituted aryl group include an aryl group (e.g., phenyl), a halogen atom, an alkoxy group, a carboalkoxy group, a carboaryloxy group, an acyl group, a nitro group, a dialkylamino group, and a sulfonyl derivative group. R1 and R2 may be bonded to each other to form, along with the nitrogen atom to which they are bonded, a heterocyclic ring containing a non-metallic atom. Examples of the heterocyclic ring include the following:

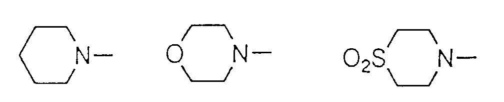

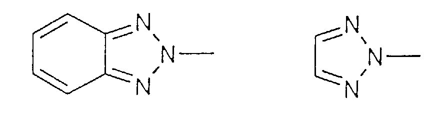

Specific examples of the compound represented by formula (II) include 2,4-bis(trichloromethyl)-6-p-methoxystyryl-s-triazine, 2,4-bis(trichloromethyl)-6-(1-p-dimethylaminophenyl-1,3-butadienyl)-s-triazine, and 2-trichloromethyl-4-amino-6-p-methoxystyryl-s-triazine.

Specific examples of the compound represented by formula (III) include 2-(naphtho-l-yl)-4,6-bis-trichloromethyl-s-triazine, 2-(4-methoxy-naphtho-1-yl)-4,6-bis-trichloromethyl-s-triazine, 2-(4-ethoxy-naphtho-1-yl)-4,6-bis-trichloromethyl-s-triazine, 2-(4-butoxy-naphtho-1-yl)-4,6-bis-trichloromethyl-s-triazine, 2-[4-(2-methoxyethyl)-naphtho-l-yl]-4,6-bis-trichloromethyl-s-triazine, 2-[4-(2-ethoxyethyl)naphtho-l-yl]-4,6-bis-trichloromethyl-s-triazine, 2-[4-(2-butoxyethyl)-naphtho-1-yl]-4,6-bis-trichloromethyl-s-triazine, 2-(2-methoxy-naphtho-1-yl)-4,6-bis-trichloromethyl-s-triazine, 2-(6-methoxy-5-methylnaphtho-2-yl)-4,6-bis-trichloromethyl-s-triazine, 2-(6-methoxy-naphtho-2-yl)-4,6-bis-trichloromethyl-s-triazine, 2-(5-methoxy-naphtho-l-yl)-4,6-bis-trichloromethyl-s-triazine, 2-(4,7-dimethoxy-naphtho-l-yl)-4,6-bis-trichloromethyl-s-triazine, 2-(6-ethoxy-naphtho-2-yl)-4,6-bis-trichloromethyl-s-triazine, and 2-(4,5-dimethoxynaphtho-l-yl)-4,6-bis-trichloromethyl-s-triazine.

Specific examples of the compound represented by formula (IV) include 4-(p-N,N-di(ethoxycarbonylmethyl)-aminophenyl]-2,6-di(trichloromethyl)-s-triazine, 4-[o-methyl-p-N,N-di(ethoxycarbonylmethyl)aminophenyl]-2,6-di(trichloromethyl)-s-triazine, 4-[p-N,N-di(chloroethyl)-aminophenyl]-2,6-di(trichloromethyl)-s-triazine, 4-[o-methyl-p-N,N-di(chloroethyl)aminophenyl]-2,6-di(trichloromethyl)-s-triazine, 4-(p-N-chloroethylaminophenyl)-2,6-di(trichloromethyl)-s-triazine, 4-(p-N-ethoxycarbonylmethylaminophenyl)-2,6-di(trichloromethyl)-s-triazine, 4-[p-N,N-di(phenyl)aminophenyl]-2,6-di(trichloromethyl)-s-triazine, 4-[p-N-(p-methoxyphenyl)carbonylaminophenyl]-2,6-di(trichloromethyl)-s-triazine, 4-[m-N,N-di(ethoxycarbonylmethyl)aminophenyl]-2,6-di(trichloromethyl)-s-triazine, 4-[m-bromo-p-N,N-di(ethoxycarbonylmethyl)aminophenyl]-2,6-di(trichloromethyl)-s-triazine, 4-[m-chloro-p-N,N-di(ethoxycarbonylmethyl)aminophenyl]-2,6-di(trichloromethyl)-s-triazine, 4-[m-fluoro-p-N,N-di(ethoxycarbonylmethyl)aminophenyl]-2,6-di(trichloromethyl)-s-triazine, 4-[o-bromo-p-N,N-di(ethoxycarbonylmethyl)aminophenyl]-2,6-di(trichloromethyl)-s-triazine, 4-[o-chloro-p-N,N-di(ethoxycarbonylmethyl)aminophenyl]-2,6-di(trichloromethyl)-s-triazine, 4-[o-fluoro-p-N,N-di(ethoxycarbonylmethyl)aminophenyl]-2,6-di(trichloromethyl)-s-triazine, 4-[o-bromo-p-N,N-di(chloroethyl)-aminophenyl]-2,6-di(trichloromethyl)-s-triazine, 4-[o-chloro-p-N,N-di(chloroethyl)aminophenyl]-2,6-di(trichloromethyl)-s-triazine, 4-[o-fluoro-p-N,N-di(chloroethyl)-aminophenyl]-2,6-di(trichloromethyl)-s-triazine, 4-[m-bromo-p-N,N-di(chloroethyl)aminophenyl]-2,6-di(trichloromethyl)-s-triazine, 4-[m-chloro-p-N,N-di(chloroethyl)-aminophenyl]-2,6-di(trichloromethyl)-s-triazine, -4-[m-fluoro-p-N,N-di(chloroethyl)aminophenyl]-2,6-di(trichloromethyl)-s-triazine, 4-(m-bromo-p-N-ethoxycarbonylmethylaminophenyl)-2,6-di(trichloromethyl)-s-triazine, 4-(m-chloro-p-N-ethoxycarbonylmethylaminophenyl)-2,6-di(trichloromethyl)-s-triazine, 4-(m-fluoro-p-N-ethoxycarbonylmethylaminophenyl)-2,6-di(trichloromethyl)-s-triazine, 4-(o-bromo-p-N-ethoxycarbonylmethylaminophenyl)-2,6-di(trichloromethyl)-s-triazine, 4-(o-chloro-p-N-ethoxycarbonylmethylaminophenyl)-2,6-di(trichloromethyl)-s-triazine, 4-(o-fluoro-p-N-ethoxycarbonylmethylaminophenyl)-2,6-di(trichloromethyl)-s-triazine, 4-(m-bromo-p-N-chloroethylaminophenyl)-2,6-di(trichloromethyl)-s-triazine, 4-(m-chloro-p-N-chloroethylaminophenyl)-2,6-di(trichloromethyl)-s-triazine, 4-(m-fluoro-p-N-chloroethylaminophenyl)-2,6-di(trichloromethyl 4-(o-bromo-p-N-chloroethylaminophenyl)-2,6-di(trichloromethyl)-s-triazine, 4-(o-chloro-p-N-chloroethylaminophenyl)-2,6-di(trichloromethyl)-s-triazine, and 4-(o-fluoro-p-N-chloroethylaminophenyl)-2,6-di(trichloromethyl)-s-triazine.

The 3-aryl-substituted coumarin compound (B) for use in the present invention is represented by the following formula (V).

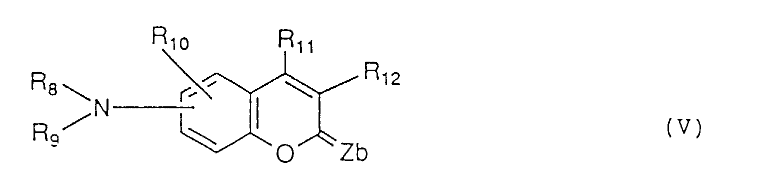

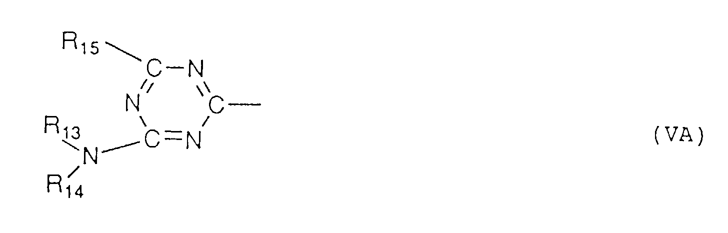

In formula (V), R₈ represents a hydrogen atom, an alkyl group having from 1 to 8 carbon atoms, or an aryl group having from 6 to 10 carbon atoms, and preferably, a hydrogen atom, a methyl group, an ethyl group, a propyl group, or a butyl group.

R₉ represents a hydrogen atom, an alkyl group having from 1 to 8 carbon atoms, an aryl group having from 6 to 10 carbon atoms, or a group represented by formula (VA), preferably a methyl group, an ethyl group, a propyl group, a butyl group, a group represented by formula (VA), and especially preferably a group represented by formula (VA).

R₁₀ and R₁₁ each independently represents a hydrogen atom, an alkyl group having from 1 to 8 carbon atoms (e.g., methyl, ethyl, propyl, butyl, octyl), a haloalkyl group having from 1 to 8 carbon atoms (e.g., chloromethyl, fluoromethyl, trifluoromethyl), an alkoxy group having from 1 to 8 carbon atoms (e.g., methoxy, ethoxy, butoxy), a substituted or unsubstituted aryl group having from 6 to 10 carbon atoms (e.g., phenyl), an amino group, -N(R₁₆)(R₁₇), or a halogen atom (e.g., -Cl, -Br, -F), and preferably a hydrogen atom, a methyl group, an ethyl group, a methoxy group, a phenyl group, -N(R₁₆)(R₁₇), or -Cl.

R₁₂ represents a substituted or unsubstituted aryl group having from 6 to 16 carbon atoms (e.g., phenyl, naphthyl, tolyl, cumyl). Examples of substituents of the substituted aryl group of R₁₂ include an amino group, -N(R₁₆)(R₁₇), an alkyl group having from 1 to 8 carbon atoms (e.g., methyl, ethyl, propyl, butyl, octyl), a haloalkyl group having from 1 to 8 carbon atoms (e.g., chloromethyl, fluoromethyl, trifluoromethyl), an alkoxy group having from 1 to 8 carbon atoms (e.g., methoxy, ethoxy, butoxy), a hydroxyl group, a cyano group, and a halogen atom (e.g., -Cl, -Br, -F).

R₁₃, R₁₄, R₁₆ and R₁₇ each independently represents a hydrogen atom, or an alkyl group having from 1 to 8 carbon atoms (e.g., methyl, ethyl, propyl, butyl, octyl). Additionally, R₁₃ and R₁₄, or R₁₆ and R₁₇ each independently may be bonded to each other to form, along with the nitrogen atom to which they are bonded, a heterocyclic ring (e.g., piperidine ring, piperazine ring, morpholine ring, pyrazole ring, diazole ring, triazole ring, benzotriazole ring).

R₁₅ represents a hydrogen atom, an alkyl group having from 1 to 8 carbon atoms (e.g., methyl, ethyl, propyl, butyl, octyl), an alkoxy group having from 1 to 8 carbon atoms (e.g., methoxy, ethoxy, butoxy), a substituted or unsubstituted aryl group having from 6 to 10 carbon atoms (e.g., phenyl), an amino group, -N(R₁₆)(R₁₇), or a halogen atom (e.g., -Cl, -Br, -F).

Zb represents =O, =S, or =C(R₁₈)(R₁₉), preferably =O, =S or =C(CN)₂, and especially preferably =O. R18 and R₁₉ each independently represent a cyano group, -COOR₂₀, or -COR₂₁. R₂₀ and R₂₁ each independently represent an alkyl group having from 1 to 8 carbon atoms (e.g., methyl, ethyl, propyl, butyl, octyl), a haloalkyl group having from 1 to 8 carbon atoms (e.g., chloromethyl, fluoromethyl, trifluoromethyl), or a substituted or unsubstituted aryl group having from 6 to 10 carbon atoms (e.g., phenyl).

Especially preferred 3-aryl-substituted coumarin compounds (B) for use in the present invention are ((s-triazin-2-yl)amino)-3-arylcoumarins represented by the following formula (VI).

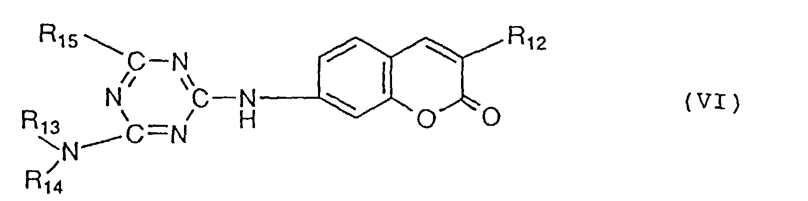

In formula (VI), R₁₂, R₁₃, R₁₄ and R₁₅ have the same meaning as those defined above, respectively.

In the present invention, the solid weight ratio of compounds (A) and (B) with respect to the photo-polymerizable ethylenically unsaturated compound is from 1 to 40%, preferably from 2 to 30%, and the ratio of (A)/(B) by weight is from 0.1/1 to 10/1, preferably from 0.2/1 to 5/1.

The photo-polymerizable ethylenically unsaturated compound (hereinafter referred to as "monomer") used in the present invention is one having at least two terminal ethylene groups and having a boiling point of 100°C or higher at normal pressure. Preferred examples thereof include acrylates and methacrylates such as polyethylene glycol di(meth)acrylate, trimethylolethane tri(meth)acrylate, pentaerythritol tri(meth)acrylate, pentaerythritol tetra(meth)acrylate, dipentaerythritol hexa(meth)acrylate, trimethylolpropane tri(acryloyloxypropanoyl) ester, tri(acryloyloxyethyl) isocyanurate; (meth)acrylates obtained by adding ethylene oxide or propylene oxide to polyfunctional alcohols, such as glycerin and trimethylolethane, followed by (meth)acrylating the resulting adducts; urethane acrylates such as those described in JP-B-48-41708, JP-B-50-6034, and JP-A-51-37193; polyester acrylates such as those described in JP-A-48-64183, JP-B-49-43191, JP-B-52-30490; and epoxy acrylates obtained by reacting an epoxy resin and (meth)acrylic acids.

Also usable in the present invention are photocuring monomers and oligomers such as those referred to in Journal of Nippon Adhesive Association, Vol. 20, pp. 300-308. The content of the monomers and/or oligomers in the photo-polymerizable composition of the present invention usually is from 5 to 50% by weight, preferably from 10 to 40% by weight, based on the total solids content in the composition. The above-mentioned monomers and oligomers may be used singly or as mixtures comprising two or more of them.

The composition of the present invention preferably contains an organic polymer having a water-soluble functional group in a part of its side chains (hereinafter referred to as a binder). The organic polymer is preferably a linear organic polymer which is miscible with the monomer in the composition, soluble in an organic solvent and developable with an aqueous weakly-alkaline solution. Examples of the linear organic polymer include a polymer having a carboxylic acid group in its side chains, for example, methacrylic acid copolymers, acrylic acid copolymers, itaconic acid copolymers, crotonic acid copolymers, maleic acid copolymers, and partially esterified maleic acid copolymers, such as those described in JP-A-59-44615, JP-B-54-34327, JP-B-58-12577, JP-B-54-25957, JP-A-59-53836, and JP-A-59-71048. Also they include derivatives of acidic cellulose having a carboxylic acid in its side chains.

In addition to these, also usable are adducts prepared by adding an acid anhydride to a polymer having a hydroxyl group. Of these, especially preferred are copolymers of benzyl (meth)acrylate/(meth)acrylic acid and multi-copolymers of benzyl (meth)acrylate, (meth)acrylic acid and other monomer. Water-soluble polymers such as polyvinyl pyrrolidone, polyethylene oxide, and polyvinyl alcohol, are also usable. In order to improve the mechanical strength of the cured film of the composition of the present invention, the composition may contain an alcohol-soluble nylon, or a polyether of 2,2-bis-(4-hydroxyphenyl)-propane and epichlorohydrin. The content of the additional polymer in the composition of the present invention may be defined freely.

The content of the binder in the photo-polymerizable composition of the present invention usually is 90% by weight or less, preferably from 30 to 85% by weight, based on the total solids content in the composition. If the content is more than 90% by weight, the binder has a bad influence on the composition in that the image density formed is thereby lowered.

In order to improve the storage stability of the photosensitive agent in the composition of the present invention, a thermal polymerization inhibitor is preferably added to the composition as is conventional. Examples of the thermal polymerization inhibitor include hydroquinone, p-methoxyphenol, di-t-butyl-p-cresol, pyrogallol, t-butyl catechol, benzoquinone, 4,4'-thiobis(3-methyl-6-t-butylphenol), 2,2'-methylene(4-methyl-6-t-butylphenol), and 2-mercaptobenzimidazole. In general, such a thermal polymerization inhibitor is added to the composition of the present invention at a concentration of from 500 to 2,000 ppm based on the monomers in the composition. Commercial monomers generally already contain a suitable amount of such a thermal polymerization inhibitor.

The photo-polymerizable composition of the present invention preferably contains a dispersion of pigment to produce a color filter. For example, the pigments are dispersed in a solution of the photo-polymerizable composition dissolved in an organic solvent by using a dispersing machine such as a roll mill, a sand mill, a ball mill or an attritor. A dispersion of carbon black or a black dispersion of a mixture comprising pigment, or dyes is used for forming a black stripe.

Examples of the pigment added to the photo-polymerizable composition of the present invention include azo pigments, anthraquinone pigments, xanthene pigments, quinacridone pigments, indigo pigments, dioxazine pigments, indanthrene pigments and isoindolinone pigments. Specific examples thereof include phthalocyanine blue pigments (e.g., C.I. Pigment Blue 15:6, C.I. Pigment Blue 15:3, such as Lionol Blue ES produced by TOYO INK MFG. CO., LTD., Chromo Blue A3R produced by Ciba-Geigy Corporation), phthalocyanine green pigments (e.g., C.I. Pigment Green 7, 36, 37, such as Lionol Green 2YS produced by TOYO INK MFG. CO., LTD.), perylene pigments (e.g., C.I. Pigment Red 155), and anthraquinone dyes (e.g., C.I. Pigment Red 177, such as Lionogen Red GD produced by TOYO INK MFG. CO., LTD., Chromophthal Red BRN produced by Ciba-Geigy Corporation). For color correction, especially preferred are C.I. Pigment Yellow 83, C.I. Pigment Yellow 154 (e.g., Lionogen Yellow 3G produced by TOYO INK MFG. CO., LTD.), and C.I. Pigment Violet 23 (e.g., Lionogen Violet RL produced by TOYO INK MFG. CO., LTD.). The content of the pigment in the photo-polymerizable composition of the present invention usually is from 5 to 90% by weight, preferably from 10 to 60% by weight, based on the total solids content of the composition.

The organic solvents used in the present invention are preferably non-toxic and excellent in coatability. Examples of the solvent include linear alkyl 3-alkoxypropionate wherein the alkoxy group is a methoxy or ethoxy group, the alkyl group is a methyl or ethyl group, and the alkoxy group is substituted at the 3-position. The larger the carbon number of the alkoxy and alkyl groups, the lower the uniformity of the coated layer is. Concretely, methyl 3-methoxypropionate, ethyl 3-methoxypropionate, methyl 3-ethoxypropionate and ethyl 3-ethoxypropionate are preferably used. Monoalkyl ether acetates of propylene glycol are also usable as the solvent. Examples thereof include propylene glycol monomethyl ether acetate, propylene glycol monoethyl ether acetate, and propylene glycol monopropyl ether acetate. In addition, propylene glycol monoalkyl ethers are also usable as the solvent. Examples thereof include propylene glycol monomethyl ether, propylene glycol monoethyl ether, and propylene glycol monopropyl ether. In addition, also usable are lactates such as methyl lactate and ethyl lactate; ketones such as methyl ethyl ketone, cyclohexanone, and methyl cyclohexanone; as well as gamma-butyrolactone, N-methylpyrrolidone, and dimethylsulfoxide.

Cellosolves, cellosolve acetates and halogen-containing solvents are excellent in coatability. However, they are unpreferable because of their low safety for human bodies. Alkyl 3-alkoxypropionates are highly safe and are therefore important for industrial use in view of the working environment in which then are used.

Examples of the method of coating the composition of the present invention include a spinner method, a roll coater method, a bar coater method, and a curtain coater method.

It is effective to add a surfactant to the coating liquid comprising the composition of the present invention. Especially effective are organopolysiloxane compounds and fluorine-containing surfactants such as those described in JP-A-2-804. The coating liquid containing such a surfactant forms a more uniform coating layer.

The initiator of the present invention can be used in the photosensitive transfer material disclosed in JP-A-5-72724, which comprises a thermoplastic resin layer, a release layer having little oxygen permeability and a photosensitive resin layer formed on a temporary support in this order and in which the adhesiveness between the thermoplastic resin layer and the release layer is the smallest. In this case, it is unnecessary to specifically define the materials constituting the release layer and the thickness of the release layer from the viewpoint of the oxygen permeability of the layer. In addition, even the provision itself of the release layer may be omitted. Therefore, the use of the initiator of the present invention in the photosensitive transfer material is advantageous in view of the steps for the process of producing the material.

Examples of developer used for the composition of the present invention include an aqueous solution comprising an alkali metal or alkaline earth metal hydroxide, carbonate or hydrogencarbonate, aqueous ammonia, or an aqueous solution comprising an alkanolamine or a quaternary ammonium salt. A suitable amount of a surfactant can be added to the developer.

The present invention will be described in more detail by means of the following examples, but it should be understood that the present invention is not to be deemed to be limited thereto.

### EXAMPLE 1

A photosensitive composition (the following formulation 1) comprising the components mentioned below was coated on a soda glass substrate having SiO₂ formed therein to prevent the dissolution of sodium ions therefrom, at a dry thickness of 2 µm. This was dried on a hot plate at 95°C for 2 minutes. For each component mentioned below, its function has been parenthesized.

### Formulation 1:

- Benzyl (meth)acrylate/methacrylic acid copolymer [70/30 by mol; mean molecular weight Σw = 20,000] (binder) 62 g
- Pentaerythritol tetraacrylate (monomer) 38 g
- 4-[o-Bromo-p-N,N-di(ethoxycarbonyl- methyl)aminophenyl]-2,6-di(trichloromethyl)-s-triazine (photo-polymerization initiator (A)) 3.8 g
- 7-((4-Chloro-6-(diethylamino)-s- triazin-2-yl)amino)-3-phenylcoumarin (photo-polymerization initiator (B)) 3.8 g
- Lionogen Red CD (C.I. Pigment Red 168) (pigment) 36 g
- Lionogen Orange R (C.I. Pigment Orange 36) (pigment) 12 g
- Hydroquinone monomethyl ether (thermal polymerization inhibitor) 0.01 g
- Ethyl 3-ethoxypropionate (solvent) 350 g
- Propylene glycol monomethyl ether 300 g acetate (solvent)

Fuji Step Guide P (produced by Fuji Photo Film Co., Ltd.) was positioned on the photosensitive layer, which was then exposed to a 2 KW high-pressure mercury lamp at 100 mJ/cm². This was thereafter developed by dipping it in an aqueous solution of 1% sodium carbonate for about one minute. The 8th step remained slightly on the pattern thus formed, while the 9th step was removed completely.

### COMPARATIVE EXAMPLE 1

### Formulation 2:

- Benzyl (meth)acrylate/methacrylic acid copolymer [70/30 by mol; mean molecular weight Σw = 20,000] (binder) 62 g
- Pentaerythritol tetraacrylate (monomer) 38 g
- 4-[o-Bromo-p-N,N-di(ethoxycarbonyl- methyl)aminophenyl]-2,6-di(trichloromethyl)-s-triazine (photo-polymerization initiator) 3.8 g
- Lionogen Red CD (C.I. Pigment Red 168) (pigment) 36 g
- Lionogen Orange R (C.I. Pigment Orange 36) (pigment) 12 g
- Hydroquinone monomethyl ether (thermal polymerization inhibitor) 0.01 g
- Ethyl 3-ethoxypropionate (solvent) 350 g
- Propylene glycol monomethyl ether 300 g acetate (solvent)

In the same manner as in Example 1, the photosensitive composition (formulation 2) comprising the components mentioned above was coated on a soda glass substrate having SiO2 formed therein, at a dry thickness of 2 µm. This was dried on a hot plate at 95°C for 2 minutes. Next, Fuji Step Guide P was positioned on the photosensitive layer, which was then exposed to a 2 KW high-pressure mercury lamp at 100 mJ/cm². This was thereafter developed by dipping it in an aqueous solution of 1% sodium carbonate for about one minute. The 5th step remained slightly on the pattern thus formed, while the 6th step was removed completely.

### COMPARATIVE EXAMPLE 2

### Formulation 3:

- Benzyl (meth)acrylate/methacrylic acid copolymer [70/30 by mol; mean molecular weight Σw = 20,000] (binder) 62 g
- Pentaerythritol tetraacrylate (monomer) 38 g
- 4-[o-Bromo-p-N,N-di(ethoxycarbonyl- methyl)aminophenyl]-2,6-di(trichloromethyl)-s-triazine (photo-polymerization initiator) 3.8 g
- 2-Benzoylmethylene-3-methyl-β-naphthothiazoline (photo-polymerization initiator) 3.8 g
- Lionogen Red CD (C.I. Pigment Red 168) (pigment) 36 g
- Lionogen Orange R (C.I. Pigment Orange 36) (pigment) 12 g
- Hydroquinone monomethyl ether (thermal polymerization inhibitor) 0.01 g
- Ethyl 3-ethoxypropionate (solvent) 350 g
- Propylene glycol monomethyl ether acetate (solvent) 300 g

In the same manner as in Example 1, the photosensitive composition (formulation 3) comprising the components mentioned above was coated on a soda glass substrate having SiO2 formed therein, at a dry thickness of 2 µm. This was dried on a hot plate at 95°C for 2 minutes. Next, Fuji Step Guide P was positioned on the photosensitive layer, which was then exposed to a 2 KW high-pressure mercury lamp at 100 mJ/cm². This was thereafter developed by dipping it in an aqueous solution of 1% sodium carbonate for about one minute. The 2nd step remained slightly on the pattern thus formed, while the 3rd step was removed completely.

### COMPARATIVE EXAMPLE 3

On the surface of the photosensitive layer formed in Comparative Example 1, coated was an aqueous solution of 5% PVA (polyvinyl alcohol) and dried at 85°C for 2 minutes. Next, Fuji Step Guide P was positioned on the PVA layer, which was then exposed to a 2 KW high-pressure mercury lamp at 20 mJ/cm². This was thereafter developed by dipping it in an aqueous solution of 1% sodium carbonate for about one minute. The 7th step remained slightly on the pattern thus formed, while the 8th step was removed completely.

### COMPARATIVE EXAMPLE 4

On the surface of the photosensitive layer formed in Comparative Example 2, coated was an aqueous solution of 5% PVA (polyvinyl alcohol) and dried at 85°C for 2 minutes. Next, Fuji Step Guide P was positioned on the PVA layer, which was then exposed to a 2 KW high-pressure mercury lamp at 20 mJ/cm². This was thereafter developed by dipping it in an aqueous solution of 1% sodium carbonate for about one minute. The 9th step remained slightly on the pattern thus formed, while the 10th step was removed completely.

From the data of the step guide appeared on the pattern formed in each of Example 1 and Comparative Examples 1 to 4, the sensitivity of the photosensitive layer that formed the pattern was obtained. The results are shown in Table 1 below.

**Table 1**

| Example No. | Step Guide | Oxygen-Blocking Film | Energy for Exposure (mJ/cm²) |
|---|---|---|---|
| Example 1 | 8/9 | No | 100 |
| Comparative Example 1 | 5/6 | No | 100 |
| Comparative Example 2 | 2/3 | No | 100 |
| Comparative Example 3 | 7/8 | Yes | 20 |
| Comparative Example 4 | 9/10 | Yes | 20 |

The step guide used herein has a gray scale of 15 steps, in which the density varies by square root 2 between the adjacent steps. Therefore, the increase of two steps in this step guide means the increase of two times in the sensitivity of the photosensitive layer.

Example 1 is different from Comparative Example 1 only in that the photosensitive composition of the former contained 7-((4-chloro-6-(diethylamino)-s-triazin-2-yl)amino)-3-phenylcoumarin while that of the latter did not, by which the the step guide appeared in the pattern formed in Example 1 was higher by 3 steps than that appeared in the pattern formed in Comparative Example 1. This means that the sensitivity of the photosensitive layer in Example 1 was higher by more than 2 times than that of the photosensitive layer in Comparative Example 1.

Comparative Example 2 is different from Comparative Example 1 only in that the photosensitive composition of the former contained 2-benzoylmethylene-3-methyl-β-naphthothiazoline while that of the latter did not, by which the the step guide appeared in the pattern formed in Comparative Example 2 was lower by 3 steps than that appeared in the pattern formed in Comparative Example 1. This means that the sensitivity of the photosensitive layer in Comparative Example 2 was lowered to less than 1/2 of that of the photosensitive layer in Comparative Example 1 due to the addition of 2-benzoylmethylene-3-methyl-β-naphthothiazoline to the composition of Comparative Example 2. However, it is known that, when the exposure of the photosensitive layers of Comparative Example 1 and Comparative Example 2 was conducted via the oxygen-blocking PVA layer, then the sensitivity of these layers was increased to be almost comparable to or higher than the sensitivity of the photosensitive layer having the composition of the present invention.

According to the present invention, it is possible to obtain a photosensitive material capable of forming an image at a practical sensitivity even in the absence of an oxygen-blocking layer.

According to the present invention, therefore, the steps of coating a polyvinyl alcohol layer and removing it after exposure are unnecessary, the cost of the material of polyvinyl alcohol is omitted, the decrease in the yield due to the additional steps of coating and removing polyvinyl alcohol is prevented, and the costs for the devices for coating polyvinyl alcohol and also those for the space for the coating devices are omitted.

The composition of the present invention can be applied to the field where the exposure of photosensitive compositions has heretofore been conducted in the absence of an oxygen-blocking film, while shortening the time for exposing the composition, since the composition of the present invention has high sensitivity. To expose the composition of the present invention, even exposure devices having low energy intensity can be employed.

Using the composition of the present invention, it is possible to produce accurate pixels in unlimited working conditions.

## Claims

1. A photopolymerizable composition comprising
(1) at least one photopolymerizable ethylenically unsaturated compound having at least two terminal ethylene groups and having a boiling point of 100°C or higher at normal pressure, and
(2) an addition polymerization initiator activated by irradiation with an active electromagnetic wave, said inititator comprising a combination of a compound of the following general formula (V) and at least one compound selected from those of the following general formulae (II), (III) and (IV): 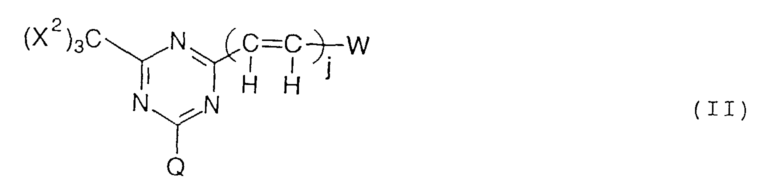 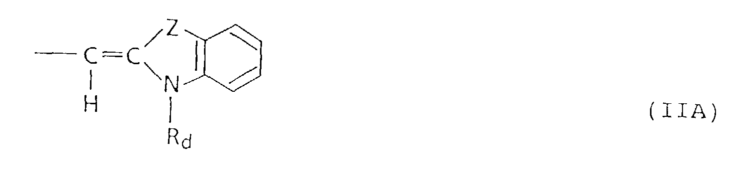
wherein X² represents -Br or -Cl;
Q represents -CX₃, -NH₂, -NHRb or -ORc, in which Rb and Rc each independently represents a phenyl group or an alkyl group;
W represents an aromatic or heterocyclic group which may be substituted or a group represented by formula (IIA);
Z represents -O- or -S-;
Rd represents a hydrogen atom, an aryl group or an alkyl group; and
j represents 0 or an integer of from 1 to 3; 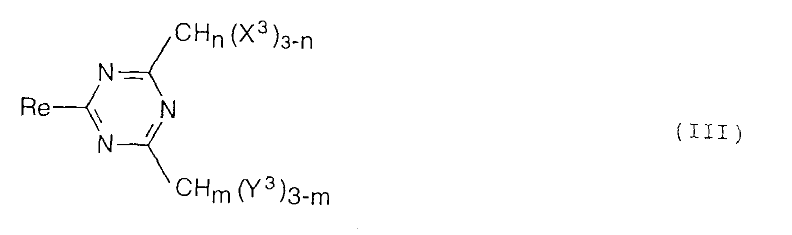 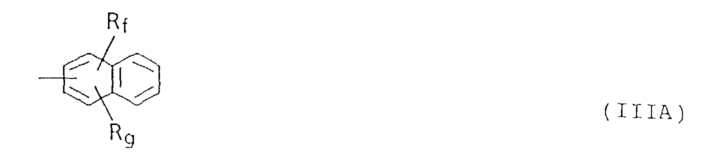
wherein X³ and Y³ each independently represents -Br or -Cl;
m and n each independently represents 0 or an integer of from 1 to 3; provided that they are not 3 at the same time;
Re represents a group represented by formula (IIIA);
Rf represents -H or -OR, in which R represents an alkyl group, a cycloalkyl group, an alkenyl group or an aryl group; and
Rg represents -H, -Cl, -Br, an alkyl group, an alkenyl group, an aryl group or an alkoxy group; 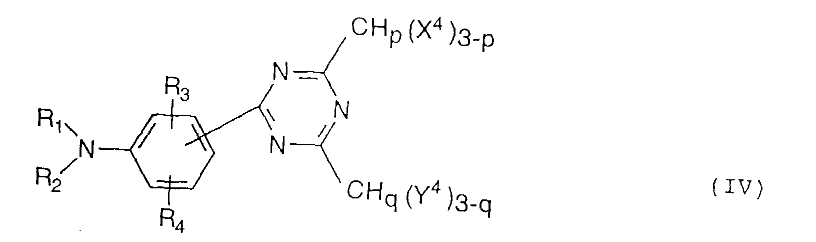 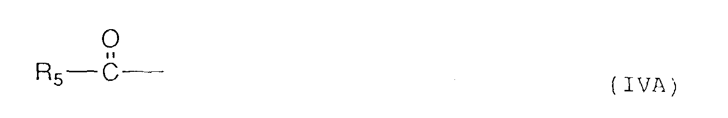 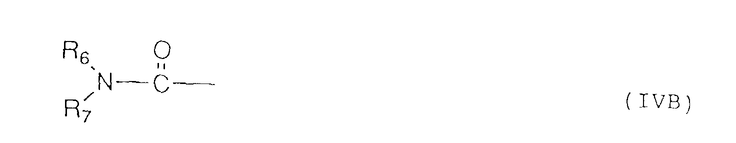
wherein R₁ and R₂ each independently represents -H, an alkyl group, a substituted alkyl group, an aryl group, a substituted aryl group, or a group represented by formula (IVA) or (IVB):
R₃ and R₄ each independently represents -H, a halogen atom, an alkyl group or an alkoxy group;
X⁴ and Y⁴ each independently represents -Cl or -Br;
p and q each independently represents 0, 1 or 2; and
R₅, R₆ and R₇ each independently represents an alkyl group, a substituted alkyl group, an aryl group or a substituted aryl group; 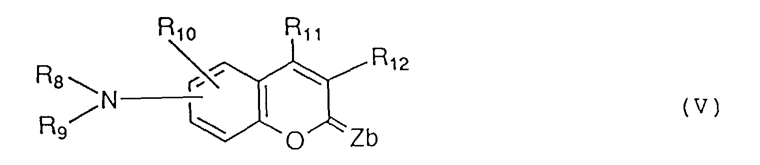 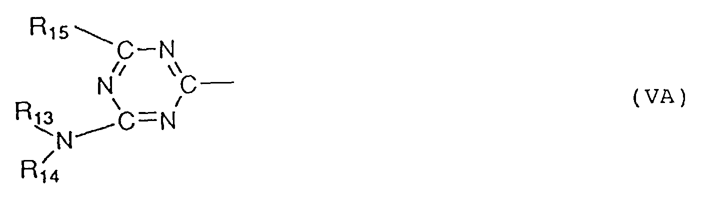
wherein R₈ represents a hydrogen atom, an alkyl group having from 1 to 8 carbon atoms, or an aryl group having from 6 to 10 carbon atoms;
R₉ represents a hydrogen atom, an alkyl group having from 1 to 8 carbon atoms, an aryl group having 6 to 10 carbon atoms, or a group represented by formula (VA);
R₁₀ and R₁₁ each independently represents a hydrogen atom, an alkyl group having from 1 to 8 carbon atoms, a haloalkyl group having from 1 to 8 carbon atoms, an alkoxy group having from 1 to 8 carbon atoms, a substituted or unsubstituted aryl group having from 6 to 10 carbon atoms, an amino group, -N(R₁₆)(R₁₇) or a halogen atom;
R₁₂ represents a substituted or unsubstituted aryl group having from 6 to 16 carbon atoms;
R₁₃, R₁₄, R₁₆ and R₁₇ each independently represents a hydrogen atom or an alkyl group having from 1 to 8 carbon atoms; or R₁₃ and R₁₄ or R₁₆ and R₁₇ each independently may be bonded to each other to form, together with the nitrogen atom to which they are bonded, a heterocyclic ring;
R₁₅ represents a hydrogen atom, an alkyl group having from 1 to 8 carbon atoms, an alkoxy group having from 1 to 8 carbon atoms, a substituted or unsubstituted aryl group having from 6 to 10 carbon atoms, an amino group, -N(R₁₆)(R₁₁) or a halogen atom;
Zb represents =O, =S or =C(R₁₈)(R₁₉);
R₁₈ and R₁₉ each independently represents a cyano group, -COOR₂₀ or -COR₂₁;
R₂₀ and R₂₁ each independently represents an alkyl group having from 1 to 8 carbon atoms, a haloalkyl group having from 1 to 8 carbon atoms, or a substituted or unsubstituted aryl group having from 6 to 10 carbon atoms.

2. The photopolymerizable composition as in claim 1, which further contains an organic polymer having a water-soluble functional group in a part of its side chains.

3. The photopolymerizable composition as in claim 1 or 2, which further contains an organic pigment.

4. The photopolymerizable composition as in claim 1 - 3, which further contains (a) an organic polymer having a water-soluble functional group in a part of its side chains and (b) an organic pigment.

5. A process for forming an image, which comprises the steps of
coating a photopolymerizable composition on a substrate surface, and exposing and developing it,
wherein the photopolymerizable composition is as defined in any one of claims 1 to 4.

6. A color filter obtainable by repeating an operation comprising the following steps:
coating a transparent substrate surface with a photopolymerizable composition containing (a) an organic polymer having a water-soluble functional group in a part of its side chains and (b) an organic pigment, and
exposing and developing it,
thereby forming red, green and blue patterns on one and the same surface of the transparent substrate,
wherein the photopolymerizable composition is as defined in claim 1.

## Patentansprüche

1. Photopolymerisierbare Zusammensetzung, umfassend
(1) mindestens eine photopolymerisierbare, ethylenisch ungesättigte Verbindung mit mindestens zwei endständigen Ethylengruppen und mit einem Siedepunkt von 100°C oder höher bei Normaldruck und
(2) einen Additionspolymerisations-lnitiator, der durch Bestrahlung mit einer wirksamen elektromagnetischen Welle aktiviert wird, wobei der Initiator eine Kombination aus einer Verbindung der folgenden allgemeinen Formel (V) und mindestens einer Verbindung, ausgewählt aus denen der folgenden allgemeinen Formeln (11), (III) und (IV) umfaßt: 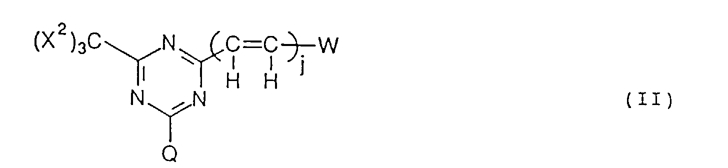 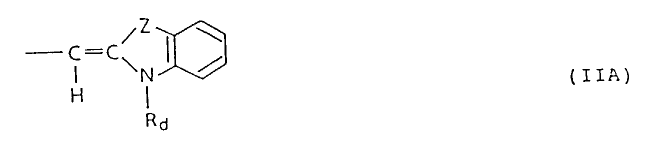
worin X² -Br oder -Cl ist;
Q -CX₃, -NH₂, -NHRb oder -ORc ist, worin Rb und Rc jeweils unabhängig eine Phenylgruppe oder eine Alkylgruppe sind;
W eine aromatische oder heterocyclische Gruppe, die substituiert sein kann, oder eine durch Formel (IIA) dargestellte Gruppe ist;
Z -O- oder -S- ist;
Rd ein Wasserstoffatom, eine Arylgruppe oder eine Alkylgruppe ist; und
j 0 oder eine ganze Zahl von 1 bis 3 ist; 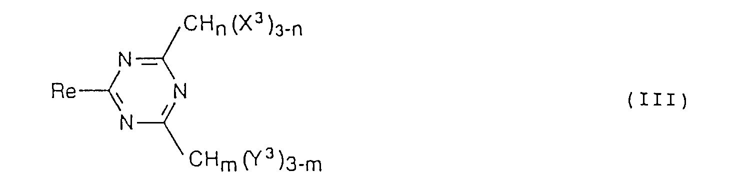 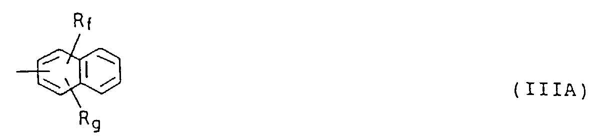
worin X³ und Y³ jeweils unabhängig -Br oder -Cl sind;
m und n jeweils unabhängig 0 oder eine ganze Zahl von 1 bis 3 sind; vorausgesetzt, daß sie nicht gleichzeitig 3 sind;
Re eine durch Formel (IIIA) dargestellte Gruppe ist;
Rf -H oder -OR ist, worin R eine Alkylgruppe, eine Cycloalkylgruppe, eine Alkenylgruppe oder eine Arylgruppe ist; und
Rg -H, -Cl, -Br, eine Alkylgruppe, eine Alkenylgruppe, eine Arylgruppe oder eine Alkoxygruppe ist; 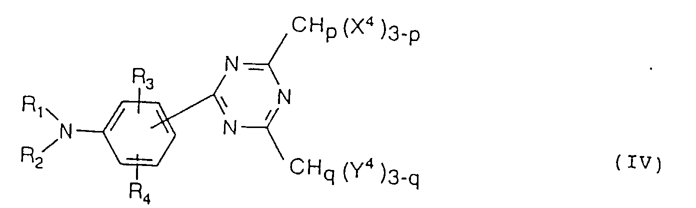 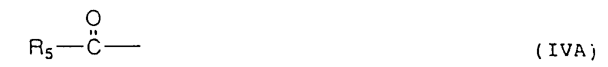 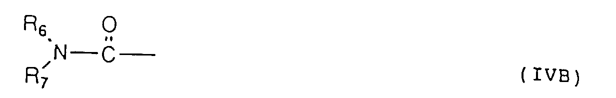
worin R₁ und R₂ jeweils unabhängig -H, eine Alkylgruppe, eine substituierte Alkylgruppe, eine Arylgruppe, eine substituierte Arylgruppe oder eine durch Formel (IVA) oder (IVB) dargestellte Gruppe sind;
R₃ und R₄ jeweils unabhängig -H, ein Halogenatom, eine Alkylgruppe oder eine Alkoxygruppe sind;
X⁴ und Y⁴ jeweils unabhängig -Cl oder -Br sind;
p und q jeweils unabhängig 0, 1 oder 2 sind; und
R₅, R₆ und R₇ jeweils unabhängig eine Alkylgruppe, eine substituierte Alkylgruppe, eine Arylgruppe oder eine substituierte Arylgruppe sind; 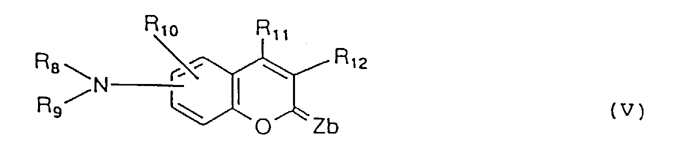 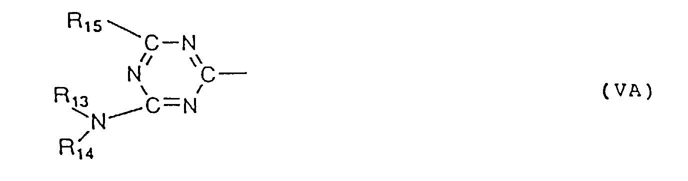
worin R₈ ein Wasserstoffatom, eine Alkylgruppe mit 1 bis 8 Kohlenstoffatomen oder eine Arylgruppe mit 6 bis 10 Kohlenstoffatomen ist;
R₉ ein Wasserstoffatom, eine Alkylgruppe mit 1 bis 8 Kohlenstoffatomen, eine Arylgruppe mit 6 bis 10 Kohlenstoffatomen oder eine durch Formel (VA) dargestellte Gruppe ist;
R₁₀ und R₁₁ jeweils unabhängig ein Wasserstoffatom, eine Alkylgruppe mit 1 bis 8 Kohlenstoffatomen, eine Halogenalkylgruppe mit 1 bis 8 Kohlenstoffatomen, eine Alkoxygruppe mit 1 bis 8 Kohlenstoffatomen, eine substituierte oder unsubstituierte Arylgruppe mit 6 bis 10 Kohlenstoffatomen, eine Aminogruppe, -N(R₁₆)(R₁₇) oder ein Halogenatom sind;
R₁₂ eine substituierte oder unsubstituierte Arylgruppe mit 6 bis 16 Kohlenstoffatomen ist;
R₁₃, R₁₄, R₁₆ und R₁₇ jeweils unabhängig ein Wasserstoffatom oder eine Alkylgruppe mit 1 bis 8 Kohlenstoffatomen sind; oder R₁₃ und R₁₄ oder R₁₆ und R₁₇ jeweils unabhängig miteinander verbunden sein können, um zusammen mit dem Stickstoffatom, an das sie gebunden sind, einen heterocyclischen Ring zu bilden;
R₁₅ ein Wasserstoffatom, eine Alkylgruppe mit 1 bis 8 Kohlenstoffatomen, eine Alkoxygruppe mit 1 bis 8 Kohlenstoffatomen, eine substituierte oder unsubstituierte Arylgruppe mit 6 bis 10 Kohlenstoffatomen, eine Aminogruppe, -N(R₁₆)(R₁₇) oder ein Halogenatom ist;
Zb =O, =S oder =C(R₁₈)(R₁₉) ist;
R₁₈ und R₁₉ jeweils unabhängig eine Cyangruppe, -COOR₂₀ oder -COR₂₁ sind;
R₂₀ und R₂₁ jeweils unabhängig eine Alkylgruppe mit 1 bis 8 Kohlenstoffatomen, eine Halogenalkylgruppe mit 1 bis 8 Kohlenstoffatomen oder eine substituierte oder unsubstituierte Arylgruppe mit 6 bis 10 Kohlenstoffatomen sind.

2. Photopolymerisierbare Zusammensetzung wie in Anspruch 1, die ferner ein organisches Polymer mit einer wasserlöslichen funktionellen Gruppe in einem Teil ihrer Seitenketten enthält.

3. Photopolymerisierbare Zusammensetzung wie in Anspruch 1 oder 2, die ferner ein organisches Pigment enthält.

4. Photopolymerisierbare Zusammensetzung wie in Anspruch 1 bis 3, die ferner (a) ein organisches Polymer mit einer wasserlöslichen funktionellen Gruppe in einem Teil ihrer Seitenketten und (b) ein organisches Pigment enthält.

5. Verfahren zur Herstellung eines Bildes, das die Schritte
Auftragen einer photopolymerisierbaren Zusammensetzung auf eine Substratoberfläche und
deren Belichtung und Entwicklung,
umfaßt, worin die photopolymerisierbare Zusammensetzung wie in irgendeinem der Ansprüche 1 bis 4 definiert ist.

6. Farbfilter, erhältlich durch Wiederholen eines Verfahrens, das die folgenden Schritte umfaßt:
Beschichten einer transparenten Substratoberfläche mit einer photopolymerisierbaren Zusammensetzung, die (a) ein organisches Polymer mit einer wasserlöslichen funktionellen Gruppe in einem Teil ihrer Seitenketten und (b) ein organisches Pigment enthält, und
deren Belichtung und Entwicklung,
wodurch rote, grüne und blaue Muster auf ein und derselben Oberfläche des transparenten Substrats gebildet werden, worin die photopolymerisierbare Zusammensetzung wie in Anspruch 1 definiert ist.

## Revendications

1. Composition photopolymérisable comportant:
(1) au moins un composant photopolymérisable éthyléniquement insaturé, présentant au moins deux groupes terminaux éthylénique et un point d'ébullition à pression normale de 100°C ou plus, et
(2) un initiateur de polymérisation par addition activé par irradiation par une onde électromagnétique active, ledit initiateur comportant une combinaison d'un composé de la formule générale (V) ci-dessous et d'au moins un composé choisi parmi ceux des formules générales (II), (III) et (IV) ci-dessous: 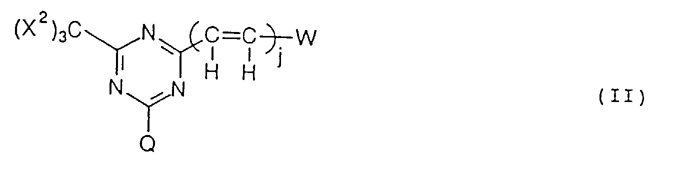 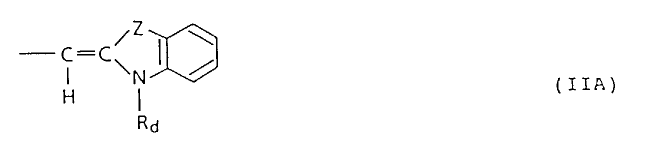
dans lesquelles X² représente -Br ou -Cl;
Q représente -CX₃, -NH₂, -NHRb ou -ORc, où Rb et Rc représentent chacun indépendamment un groupe phényle ou un groupe alkyle;
W représente un groupe aromatique ou hétérocyclique qui peut être substitué, ou un groupe représenté par la formule (IIA);
Z représente -O- ou -S-;
Rd représente un atome d'hydrogène, un groupe aryle ou un groupe alkyl; et
j représente 0 ou un entier de 1 à 3; 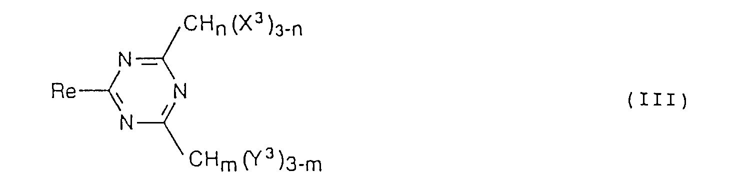 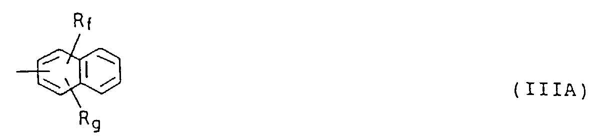
dans lesquelles X³ et Y³ représentent chacun indépendamment -Br ou - Cl;
m et n représentent chacun indépendamment 0 ou un entier de 1 à 3; pour autant qu'ils ne représentent pas simultanément 3;
Re représente un groupe représenté par la formule (IIIA);
Rf représente -H ou -OR, où R représente un groupe alkyle, un groupe cycloalkyle, un groupe alcényle ou un groupe aryl; et
Rg représente -H, -Cl, -Br, un groupe alkyle, un groupe alcényle, un groupe aryle ou un groupe alcoxy; 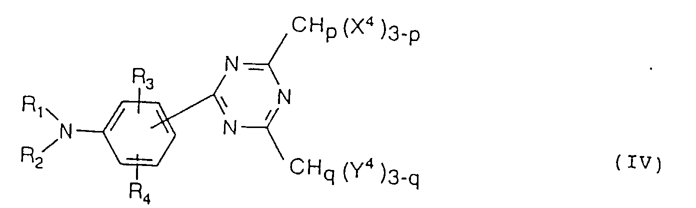 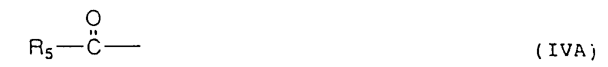 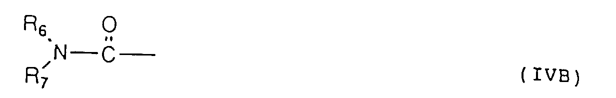
dans lesquelles R₁ et R₂ représentent chacun indépendamment -H, un groupe alkyle, un groupe alkyle substitué, un groupe aryle, un groupe aryle substitué ou un groupe représenté par la formule (IVA) ou (IVB):
R₃ et R₄ représentent chacun indépendamment -H, un atome d'halogène, un groupe alkyle ou un groupe alcoxy;
X⁴ et Y⁴ représentent chacun indépendamment -Cl ou -Br;
p et q représentent chacun indépendamment 0, 1 ou 2; et
R₅, R₆ et R₇ représentent chacun indépendamment un groupe alkyle, un groupe alkyle substitué, un groupe aryle ou un groupe aryle substitué; 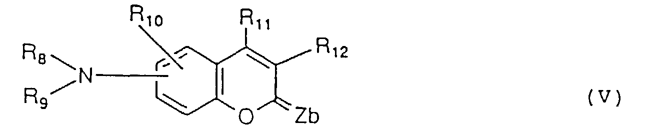 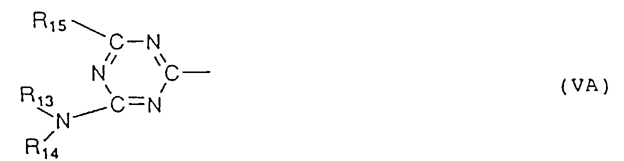
dans lesquelles R₈ représente un atome d'hydrogène, un groupe alkyle comptant de 1 à 8 atomes de carbone ou un groupe aryle comptant de 6 à 10 atomes de carbone;
R₉ représente un atome d'hydrogène, un groupe alkyle comptant de 1 à 8 atomes de carbone, un groupe aryle comptant de 6 à 10 atomes de carbone ou un groupe représenté par la formule (VA);
R₁₀ et R₁₁ représentent chacun indépendamment un atome d'hydrogène, un groupe alkyle comptant de 1 à 8 atomes de carbone, un groupe halogénoalkyle comptant de 1 à 8 atomes de carbone, un groupe alcoxy comptant de 1 à 8 atomes de carbone, un groupe aryle substitué ou non substitué comptant de 6 à 10 atomes de carbone, un groupe amino, -N(R₁₆)(R₁₇) ou un atome d'halogène;
R₁₂ représente un groupe aryle substitué ou non substitué comptant de 6 à 16 atomes de carbone;
R₁₃, R₁₄, R₁₆ et R₁₇ représentent chacun indépendamment un atome d'hydrogène ou un groupe alkyle comptant de 1 à 8 atomes de carbone; ou R₁₃ et R₁₄ ou R₁₆ et R₁₇ peuvent être liés chacun indépendamment l'un à l'autre pour former un hétérocycle avec l'atome d'azote auquel ils sont liés;
R₁₅ représente un atome d'hydrogène, un groupe alkyle comptant de 1 à 8 atomes de carbone, un groupe alcoxy comptant de 1 à 8 atomes de carbone, un groupe aryle substitué ou non substitué comptant de 6 à 10 atomes de carbone, un groupe amino -N(R₁₆)(R₁₇) ou un atome d'halogène;
Zb représente =O, =S ou =C(R₁₈)(R₁₉);
R₁₈ et R₁₉ représentent chacun indépendamment un groupe cyano, -COOR₂₀ ou -COR₂₁;
R₂₀ et R₂₁ représentent chacun indépendamment un groupe alkyle comptant de 1 à 8 atomes de carbone, un groupe halogénoalkyle comptant de 1 à 8 atomes de carbone ou un groupe aryle substitué ou non substitué, comptant de 6 à 10 atomes de carbone.

2. Composition photopolymérisable selon la revendication 1, qui contient en outre un polymère organique présentant un groupe fonctionnel soluble dans l'eau dans une partie de ses chaînes latérales.

3. Composition photopolymérisable selon la revendication 1 ou 2, qui contient en outre un pigment organique.

4. Composition photopolymérisable selon les revendications 1 à 3, qui contient en outre (a) un polymère organique présentant un groupe fonctionnel soluble dans l'eau dans une partie de ses chaînes latérales et (b) un pigment organique.

5. Procédé de formation d'une image, qui comporte les étapes consistant à:
appliquer une composition photopolymérisable sur une surface de support,
et l'exposer et la développer,
dans laquelle la composition photopolymérisable est telle que définie dans l'une quelconque des revendications 1 à 4.

6. Filtre coloré obtenu en répétant une opération comportant les étapes ci-dessous:
recouvrir une surface d'un support transparent d'une composition photopolymérisable contenant (a) un polymère organique présentant un groupe fonctionnel soluble dans l'eau dans une partie de ses chaînes latérales et (b) un pigment organique, et
l'exposer et la développer,
pour ainsi former des motifs rouges, verts et bleus sur une seule et même surface du support transparent,
dans lequel la composition photopolymérisable est telle que définie dans la revendication 1.
